# EUROPEAN PATENT SPECIFICATION

(11) **EP 1 109 233 B1**
(45) Date of publication and mention of the grant of the patent: **30.01.2002**
(21) Application number: 99830726.8
(22) Date of filing: 25.11.1999
(51) Int. Cl.: H01L 41/09

(54) **Hook-shaped piezoelectric actuator**
Hakenförmiger piezoelektrischer Antrieb
Organe d'actionnement pièzoélectrique en forme de crochet

(43) Date of publication of application: 20.06.2001
(73) Proprietor: C.R.F. Società Consortile per Azioni, 10043 Orbassano (Torino) (IT)
(72) Inventor: Perlo, Piero, c/o C.R.F., 10043 Orbassano (Torino) (IT); Pizzi, Marco, c/o C.R.F., 10043 Orbassano (Torino) (IT); Sinesi, Sabino, c/o C.R.F., 10043 Orbassano (Torino) (IT); Lambertini, Vito, c/o C.R.F., 10043 Orbassano (Torino) (IT)
(74) Representative: Notaro, Giancarlo

(56) References cited:
- EP-A- 0 706 226
- PATENT ABSTRACTS OF JAPAN vol. 013, no. 558 (E-858), 12 December 1989 (1989-12-12) & JP 01 231668 A (SEIKO ELECTRONIC COMPONENTS LTD), 14 September 1989 (1989-09-14)

## Description

The present invention relates to the field of piezoelectric actuators and has the object of providing an actuator of this type which is simple and of relatively low cost, as well as of reduced dimensions while being at the same time adapted to be used efficiently in various applications in micro-mechanics.

In view of achieving this object, the invention provides a piezoelectric actuator, comprising a metal sheet including a first base portion and a second portion inclined substantially at 90 degrees relative to the first portion and ending with a free end edge acting as a driving member, said actuator further comprising a pair of piezoelectric elements respectively applied to the two above mentioned sheet portions, and electric supply means adapted to supply an electric voltage separately to the two above mentioned piezoelectric elements.

The above mentioned electric supply means are adapted to supply the two piezoelectric elements with two alternated voltages which are 90 degrees out of phase relative to each other. In this manner, the two piezoelectric elements are cyclically deflected giving rise to an hellipsoidal motion of the end free edge of the sheet which can be exploited to repeatedly transmit a force by contact friction in the direction of the major axis of the hellipse to a driven member which is in contact with said end edge.

In a preferred embodiment, the above mentioned sheet is obtained by forming a U-shaped cut in a base plate and bending the sheet which is thus obtained by this cutting at mid length thereof by 90 degrees. The two piezoelectric elements may be constituted by sheets applied by screen-printing.

According to a possible variant, in the base plate a plurality of sheets are formed by cutting which are bent in the above described manner, so as to provide a plurality of actuators which are arranged side-by-side and/or in line with each other.

Further features and advantages of the invention will become apparent from the description which follows with reference to the annexed drawings, given purely by way of non limiting example, in which:
figure 1 is a diagrammatic plan view of an actuator according to the invention with the actuator sheet shown in the planar condition, before being bent,
figure 2 is a side view of the actuator according to the invention, in its operative condition,
figure 3 is a perspective view of the actuator of figure 2,
figure 4 shows two possible diagrams of the supply voltage of each piezoelectric element of the actuator according to the invention,
figure 5 shows two diagrams which show the movement of points A and B of the actuator, and
figure 6 is a diagram which shows the path of the movement of the end free edge of the actuator.

In the drawings, reference numeral 1 designates a steel sheet having a thickness in the order of hundredths of millimeter, in which a U-shaped cut 2 is formed to define a sheet 3 having a first base portion 4 which is adapted to be deflected with respect to one side 5 connected to the base plate 1, and a second portion 6 which is bent by about 90 degrees out of the plane of the base plate 1 at an intermediate bending edge 7. On the two portions 4, 6 two piezoelectric elements 8, 9 are applied, such as by screen-printing, which elements are in form of sheets each having a thickness between 10 and 30 micrometers. It is clearly apparent that the application of the two piezoelectric layers 8, 9 may be obtained according to any known technology, such as by dipping. According to the invention, preferably the two piedroelectric layers are applied before cut 2 is formed.

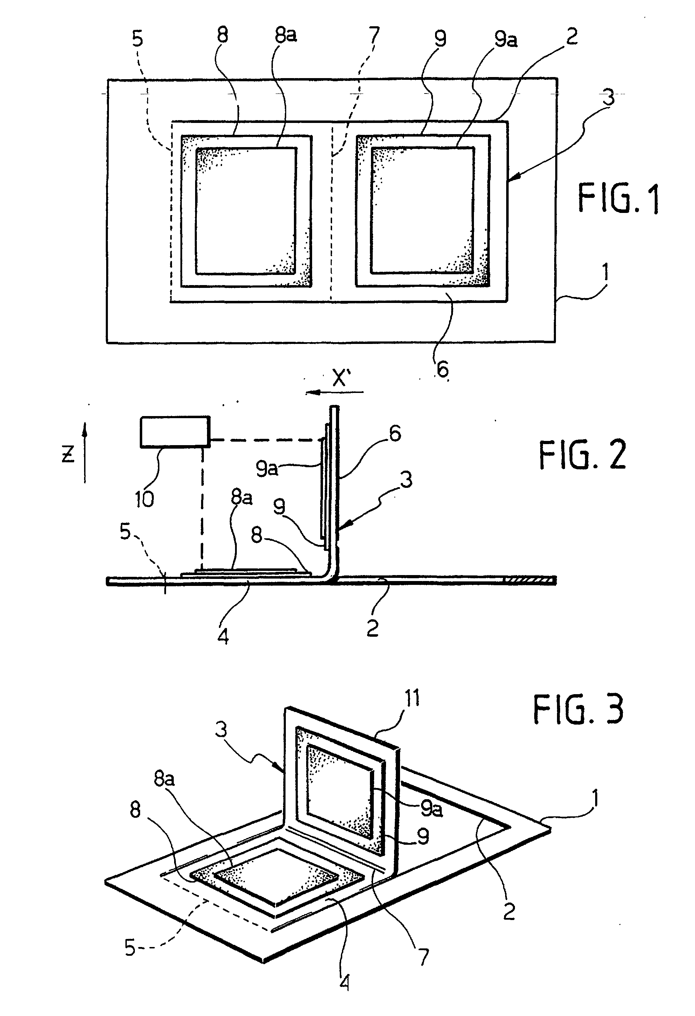

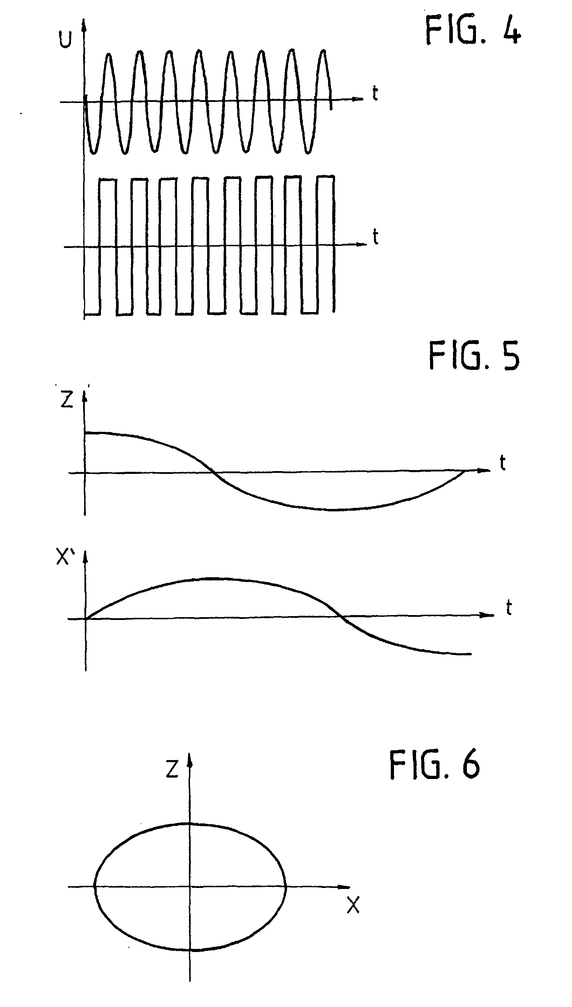

The two piezoelectric elements 8, 9 have respectively electrodes 8, 9 which are connected to electric supply means 10. The two piezelectric elements 8, 9 are supplied with an alternated electric voltage, of sinusoidal or square shape, as shown in figure 4. In the supply frequence depends upon the dimensions of the actuator, which may vary from some fraction of millimeter to some millimeters. The two piezoelectric elements are supplied by the same signal out of phase by 90 degrees. The upper portion of the diagram of figure 5 shows the movement of the edge 7 in the direction of the Z axis, whereas the lower part shows the movement of the free end edge of sheet 6 (designated by 11) in the direction X', in a reference system (X', Y', Z') having its origin at point 7 and its axes parallel to those of the fixed reference system (X, Y, Z). The composition of the two movements causes a hellipsoidal movement of the end free edge 11 of the structure, as shown in figure 6 in the (X, Y, Z) reference system. Therefore, if the end free edge 11 is in contact by friction with the lower surface of a driven element which is to be moved in the X direction, the free edge 11 repeatedly applies a force to the driven body. Preferably, the edge 11 is provided with a coating of a material having a high friction coefficient. In operation, the two piezoelectric elements 8, 9 behave as two flexures, determining an oscillation of points 7, 11, according to what has been described in the foregoing. The direction of this movement is rightward or leftward (with reference to figure 2) depending upon the two signals supplied to the two piezoelectric elements 8, 9 being out of phase by +90 degrees or -90 degrees.

In a possible variant, in a same base plate 1 many cuts are formed so as to define a plurality of hook-like sheets similar to the above illustrated sheet 3, arranged side-by-side and/or in line with each other, so as to increase power and/or the degrees of freedom in movement.

Also the shape of the cut 2 may be different from that shown in the drawings. For instance, this cut may have a rectangular shape similar to that shown in figure 1, but with a portion connected to the base plate arranged on one side of the two piezoelectric elements 8, 9, rather than on one end. Alternatively, this cut may have a hellipsoidal shape in plan view, rather than rectangular, or it may have a thinner portion between one piezoelectric element and the other.

According to a further variant, sensor means of any type may be provided, such as of optical type, to detect the position of the driven body and thus to enable a closed loop control of the position of this body with the aid of the actuator according to the invention.
The provision of a plurality of hook-like sheets in parallel decreases the wear problems in the contact area between the edge 11 and the driven body while at same time, as already indicated, the power and/or the degrees of freedom in movement are increased.

Naturally, while the principle of the invention remains the same, the details of construction and the embodiments may widely vary with respect to what has been described and illustrated purely by way of example, without departing from the scope of the present invention as set forth in the claims.

## Claims

1. Piezoelectric actuator, comprising a metal sheet (3) including a first base portion (4) and a second portion (6) inclined substantially by 90 degrees with respect to the first portion (4) and ending with an end free edge (11) acting as driven member said actuator further comprising a pair of piezoelectric elements (8, 9) applied to the two above mentioned portions (8, 9) of the sheet (3) and electric supply means (10) for suppling an electric voltage separately to said piezoelectric elements (8, 9).

2. Actuator according to claim 1, **characterised in that** said electric supply means (10) are adapted to supply an alternated electric voltage to each piezoelectric element (8, 9), which voltage is 90 degrees out-of-phase with respect to the voltage supplied to the other piezoelectric element.

3. Actuator according to claim 1, **characterised in that** said sheet (3) is made of steel and is obtained by forming a cut (2) in the base plate (1).

4. Actuator according to claim 3, **characterised in that** said cut (2) is U-shaped.

5. Actuator according to claim 1, **characterised in that** a plurality of actuating sheets (3) are formed in the same base plate (1) and are arranged side-by-side and/or in line with each other, according to similar or different orientations, to increase the power of the actuator and/or the freedom degrees in the movement imparted.

6. Actuator according to claim 1, **characterised in that** said sheet (3) is made of steel.

7. Actuator according to claim 1, **characterised in that** said sheet (3) has a thickness in the order of hundredths of millimeter.

8. Actuator according to claim 1, **characterised in that** said piezoelectric elements (8, 9) are sheets having a thickness of 10-30 microns.

9. Actuator according to claim 8, **characterised in that** said piezoelectric elements are applied by means of screen-printing.

10. Actuator according to claim 1, **characterised in that** the free end edge (11) of the actuator is provided with a coating of a material having a high friction coefficient.

## Patentansprüche

1. Piezoelektrischer Aktuator, welcher ein Metallblatt (3) aufweist, das einen ersten Basisabschnitt (4) und einen zweiten Abschnitt (6) aufweist, der im Wesentlichen um 90 Grad bezüglich dem ersten Abschnitt (4) geneigt ist und mit einer freien Endkante (11) endet, welche als angetriebenes Element wirkt, wobei der Aktuator weiter ein Paar von piezoelektrischen Elementen (8, 9) umfasst, die an den zwei oben genannten Abschnitten (8, 9,) des Blattes (3) angebracht sind, und elektrische Versorgungsmittel (10) zur Zufuhr von elektrischer Spannung einzeln zu den piezoelektrischen Elementen (8, 9).

2. Aktuator gemäß Anspruch 1, **dadurch gekennzeichnet, dass** die elektrischen Versorgungsmittel (10) angepasst sind, um eine wechselnde elektrische Spannung jedem der piezoelektrischen Elemente (8, 9) zuzuführen, wobei die Spannung bezüglich der zu dem anderen piezoelektrischen Element zugeführten Spannung 90 Grad außerphasig ist.

3. Aktuator gemäß Anspruch 1, **dadurch gekennzeichnet, dass** das Blatt (3) aus Stahl hergestellt ist und durch Ausbilden eines Schnittes (2) in der Grundplatte (1) erhalten wird.

4. Aktuator gemäß Anspruch 3, **dadurch gekennzeichnet, dass** der Schnitt (2) U-förmig ist.

5. Aktuator gemäß Anspruch 1, **dadurch gekennzeichnet, dass** eine Mehrzahl von Betätigungsblättern (3) in der gleichen Grundplatte (1) ausgebildet sind und Seite an Seite und/oder in einer Reihe miteinander angeordnet sind, entsprechend gleichen oder unterschiedlichen Orientierungen, um die Kraft des Aktuators und/oder die damit verbundenen Freiheitsgrade in der Bewegung zu erhöhen.

6. Aktuator gemäß Anspruch 1, **dadurch gekennzeichnet, dass** das Blatt (3) aus Stahl hergestellt ist.

7. Aktuator gemäß Anspruch 1, **dadurch gekennzeichnet, dass** das Blatt (3) eine Dicke in der Größenordnung von hundertstel Millimetern aufweist.

8. Aktuator gemäß Anspruch 1, **dadurch gekennzeichnet, dass** die piezoelektrischen Elemente (8, 9) Blätter sind, welche eine Dicke von 10 bis 30 Mikron aufweisen.

9. Aktuator gemäß Anspruch 8, **dadurch gekennzeichnet, dass** die piezoelektrischen Elemente (8, 9) mittels Siebbedruckung aufgebracht werden.

10. Aktuator gemäß Anspruch 1, **dadurch gekennzeichnet, dass** die freie Endkante (11) des Aktuators mit einer Beschichtung eines Materials versehen ist, welches einen hohen Reibungskoeffizienten aufweist.

## Revendications

1. Organe piézoélectrique de manoeuvre, comprenant une feuille métallique (3) qui comporte une première partie de base (4) et une seconde partie (6) inclinée pratiquement à 90° par rapport à la première partie (4) et se terminant à un bord libre d'extrémité (11) qui agit comme organe mené, l'organe de manoeuvre comportant en outre une paire d'éléments piézoélectriques (8, 9) appliqués aux deux parties précitées (8, 9) de la feuille (3), et un dispositif (10) d'alimentation électrique destiné à transmettre une tension électrique séparément aux éléments piézoélectriques (8, 9).

2. Organe de manoeuvre selon la revendication 1, **caractérisé en ce que** le dispositif (10) d'alimentation électrique est destiné à transmettre une tension électrique qui alterne à chacun des éléments piézoélectriques (8, 9), la tension étant déphasée de 90° par rapport à la tension transmise à l'autre élément piézoélectrique.

3. Organe de manoeuvre selon la revendication 1, **caractérisé en ce que** la feuille (3) est formée d'acier et elle est obtenue par formation d'une découpe (2) dans la plaque de base (1).

4. Organe de manoeuvre selon la revendication 3, **caractérisé en ce que** la découpe (2) a une forme en U.

5. Organe de manoeuvre selon la revendication 1, **caractérisé en ce que** plusieurs feuilles de manoeuvre (3) sont formées dans la même plaque de base (1) et sont disposées côte à côte et/ou alignées mutuellement, avec des orientations semblables ou différentes, afin que la puissance de l'organe de manoeuvre et/ou les degrés de liberté du déplacement appliqué soient accrus.

6. Organe de manoeuvre selon la revendication 1, **caractérisé en ce que** la feuille (3) est formée d'acier.

7. Organe de manoeuvre selon la revendication 1, **caractérisé en ce que** la feuille (3) a une épaisseur de l'ordre de quelques centièmes de millimètres.

8. Organe de manoeuvre selon la revendication 1, **caractérisé en ce que** les éléments piézoélectriques (8, 9) sont des feuilles ayant une épaisseur comprise entre 10 et 30 µm.

9. Organe de manoeuvre selon la revendication 8, **caractérisé en ce que** les éléments piézoélectriques sont appliqués par sérigraphie.

10. Organe de manoeuvre selon la revendication 1, **caractérisé en ce que** le bord d'extrémité libre (11) de l'organe de manoeuvre a un revêtement d'un matériau ayant un coefficient de frottement élevé.
